**Europäisches Patentamt**

**European Patent Office**

**Office européen des brevets**

(19)

(11) Veröffentlichungsnummer: **0 211 366 B1**

(12) **EUROPÄISCHE PATENTSCHRIFT**

(45) Veröffentlichungstag der Patentschrift: **11.09.91**     (51) Int. Cl.⁵: **H03J 7/18**

(21) Anmeldenummer: **86110359.6**

(22) Anmeldetag: **26.07.86**

(54) **Ortsveränderliches Rundfunkgerät, wie Autoradio oder dgl., insbesondere UKW-Empfänger.**

(30) Priorität: **07.08.85 DE 3528312**

(43) Veröffentlichungstag der Anmeldung:
**25.02.87 Patentblatt 87/09**

(45) Bekanntmachung des Hinweises auf die
Patenterteilung:
**11.09.91 Patentblatt 91/37**

(84) Benannte Vertragsstaaten:
**AT CH DE FR GB IT LI SE**

(56) Entgegenhaltungen:
**DE-A- 3 034 155**
**DE-A- 3 130 864**
**DE-A- 3 148 085**

(73) Patentinhaber: **Blaupunkt-Werke GmbH**
**Robert-Bosch-Strasse 200**
**W-3200 Hildesheim(DE)**

(72) Erfinder: **Seibold, Peter, Dipl.-Ing.**
**Lehmkamp 33d**
**W-3201 Diekholzen(DE)**

(74) Vertreter: **Eilers, Norbert, Dipl.-Phys.**
**Blaupunkt-Werke GmbH Robert-**
**Bosch-Strasse 200**
**W-3200 Hildesheim(DE)**

## Beschreibung

Die Erfindung betrifft ein ortsveränderliches Rundfunkgerät, wie Autoradio od.dgl., Insbesondere einen UKW-Empfänger, der im Oberbegriff des Anspruchs 1 definier-ten Gattung.

Bei einem bekannten Rundfunkempfänger dieser Art (DE-A-32 14 155) ist zum Überprüfen der Empfangsqualität der Alternativsender ein kompletter zweiter Empfangsteil mit Sendereinstellvorrichtung vorgesehen, in welchem parallel zu dem momentan gehörten Sender nacheinander die Alternativsender eingestellt und ihre Empfangsqualität, hier die Empfangsfeldstärke, mit der des momentan gehörten Senders verglichen wird. Sobald dabei ein Alternativsender eine bessere Empfangsqualität, hier eine höhere Empfangsfeldstärke, besitzt als der momentan gehörte Sender, wird der letztere durch diesen Alternativsender ersetzt, der dann hörbar geschaltet wird und den neuen gehörten Sender darstellt.

Ein solcher Rundfunkemfpänger ist wegen des erforderlichen vollständigen zweiten Empfängerzuges relativ aufwendig und immer nur als Autoradio der oberen Preiskategorie zu finden. Zwar ist in der genannten DE-A bereits vorgeschlagen worden, auf den zweiten Empfangszug zu verzichten und die Überprüfung der Alternativsender in den Sendepausen des momentan gehörten Senders durchzuführen, doch gibt diese in den relativ kurzen Pausenzeiten durchgeführte Abstimmung der Alternativsender und die Bestimmung ihrer Feldstärke infolge möglicherweise momentan auftretender Störungen eine wenig zuverlässige Aussage über deren Empfangsqualität, so daß es mitunter zu häufigem Wechsel des jeweils gehörten Senders kommt. Außerdem sind Pausenerkennungsschaltungen relativ aufwendig.

Dem Dokument DE-A-3130864 ist eine Prüfvorrichtung für die Empfangsqualität entnehmbar, die sowohl den momentan gehörten Sender als auch Alternativsender überprüft. Die Prüfvorrichtung des Rundfunkgerätes weist eine Schaltung auf, welche die Empfangsqualität des momentan gehörten Senders und die Empfangsqualität der in kurzen Stummzeiten kurzzeitig empfangenen Alternativsender abtastet, weiter eine Schaltung zur Mittelung der einem Sender zugehörigen Abtastwerte, einen Speicher zum Abspeichern der Mittelwerte und eine Vergleichsschaltung, welche die Bestauswahl anhand des Vergleichs der aktuellen Abtastwerte und der Mittelwerte trifft.

Der Erfindung liegt die Aufgabe zugrunde, einen mobilen Rundfunkempfänger der eingangs genannten Art derart zu verbessern, daß bei Vorhandensein nur eines Empfängerzuges ohne Störung des Höreindrucks des momentan gehörten Senders eine zuverlässige Abprüfung der Empfangsqualität von gehörtem Sender und Alternativsender erreicht wird und eine Umschaltung nur auf die längerfristig besseren Sender erfolgt, wobei die aktuellen Abtastwerte höher bewertet und die älteren Abtastwerte einstellbar mit geringerer Bewertung berücksichtigt werden.

Diese Aufgabe ist bei einem Rundfunkempfänger, der im Oberbegriff des Anspruchs 1 angegebenen Gattung erfindungsgemäß durch die Merkmale im Kennzeichenteil des Anspruchs 1 gelöst.

Der erfindungsgemäße Rundfunkempfänger hat den Vorteil, daß bei der Bestauswahl der Sender neben den aktuellen Meßwerten der Empfangsqualität eine Vielzahl von einzelnen, zu unterschiedlichen Zeitpunkten erfaßten Meßwerten der Empfangsqualität berücksichtigt wird, wobei die Relevanz der Einzelwerte für das Prüfergebnis noch zusätzlich berücksichtigt wird. Die Erfassung der Einzelwerte der Empfangsqualität erfolgt in extrem kurzen Stummzeiten des momentan gehörten Senders von ca. 20 ms, die bei nicht zu großer Häufigkeit von dem Hörenden nicht wahrgenommen werden. Der momentan gehörte Sender - im folgenden kurz G-Sender genannt - wird damit nur dann durch einen Alternativsender - im folgenden kurz A-Sender genannt - ersetzt, wenn dieser langfristig die bessere Empfangsqualität besitzt.

Durch die Mittelung der Abtast- oder Meßwerte der Empfangsqualität, die der Filterung mittels eines digitalen rekursiven Tiefpasses erster Ordnung oder in etwa der-Filterung mittels eines analogen RC-Tiefpasses entspricht, wird eine Bewertung der Empfangsqualität erzielt, die einen optimalen Höreindruck berücksichtigt. Dabei ist es ausreichend, die Abprüfung der Empfangsqualität, die modulationsabhängig ist und statischen Charakter hat, nur relativ selten, d.h. im Abstand von 5 s - 30 s, je nach Güte der Empfangsqualität durchzuführen. Die Einstellung des Verknüpfungsfaktors $k$ wird dabei den Gegebenheiten angepaßt. Für den ersten Abtastwert liegt $k$ nahe O, da dieser Meßwert hohe Relevanz hat, während er bei relativ konstanter, d.h. wenig schwankender, oder zunehmender Empfangsqualität in Nähe 1 liegt, wodurch stark gemittelt wird. Ist die momentane Empfangsqualität wesentlich schlechter als die gemittelte, so liegt $k$ wiederum nahe O, so daß der Abtast- oder Meßwert sehr stark den Mittelwert beeinflußt. Letzteres ist insofern sinnvoll, da z.B. einzelne starke und zeitlich kurze Störungen subjektiv viel stärker empfunden werden als es ihrem Gewicht entspricht und damit den Höreindruck sehr stark beeinträchtigen. Diese Veränderung des verknüpfungsfaktors $k$ kann in einfacher Weise nach einer vorgegebenen Festlegung in Abhängigkeit von dem Vergleichsergebnis, z.B. der Differenz, aus momentanem Abtast- oder Meßwert und Mittelwert erfolgen.

Eine vorteilhafte Ausführungsform der Erfindung ergibt sich auch aus Anspruch 2. Durch diese Maßnahme werden unnötige Stummschaltungen vermieden. Die Empfangsqualität des G-Senders wird aber laufend überprüft und das Prüfergebnis durch Mittellng über eine stetig wachsende Zahl von Abtastwerten laufend verbessert.

Eine vorteilhafte Ausführungsform der Erfindung ergibt sich auch aus Anspruch 3. Durch diese Maßnahmen wird die Empfangsqualitätsprüfung optimiert; denn Empfangsqualitätsprüfung durch Prüfung der Feldstärke allein ist nur dann ausreichend, wenn ideale, d.h. ungestörte Empfangsverhältnisse vorliegen. In diesem Fall ist die Empfangsqualität proportional zu der Empfangsfeldstärke. Beim mobilen Rundfunkempfänger, dem Autoradio, mindert aber auch der Mehrwegeempfang oder der während der Fahrt auftretende, durch Reflexionen hervorgerufene sog. Lattenzauneffekt die Empfangsqualität trotz ausreichender Feldstärke erheblich. Das mittels einer in der DE-A-31 26 224 beschriebenen Schaltungsanordnung gewonne Störfreiheitsmaß, dort mit Oualitätsmaß bezeichnet, berücksichtigt solche die Empfangsqualität störende Einflüsse. Der Pegel des Störfreiheitsmaßes ist dabei ein Maß für die Größe und Häufigkeit solcher Störungen und diesen umgekehrt proportional.

Eine vorteilhafte Weiterbildung der Erfindung ergibt sich auch aus Anspruch 4. Durch diese Maßnahme genießt bei der Bestauswahl die Feldstärke Priorität ; denn nur ausreichend große Feldstärke sichert einen akzeptablen Empfang. Ist diese aber vorhanden, so wird die Bewertung der Empfangsqualität von dem Störfreiheitsmaß bestimmt.

Eine vorteilhafte Ausführungsform der Erfindung ergibt sich auch aus Anspruch 5. Hierdurch wird erreicht, daß bei weniger befriedigender aktueller Empfangsfeldstärke sowohl des G-Senders als auch des überprüften A-Senders der A-Sender nur dann hörbar geschaltet wird, wenn seine Feldstärke längerfristig und bezüglich des Höreindrucks die bessere ist.

Eine vorteilhafte Ausführungsform der Erfindung ergibt sich aus Anspruch 6. Hierdurch wird sichergestellt, daß der geprüfte A-Sender dann nicht hörbar geschaltet und seine weitere Überprüfung abgebrochen wird, wenn seine aktuelle Empfangsfeldstärke bereits kleiner als die des G-Senders ist.

Eine vorteilhafte Ausführungsform der Erfindung ergibt sich auch aus Anspruch 7. Dadurch wird bewirkt, daß der A-Sender nicht hörbar geschaltet und seine Überprüfung bereits dann abgebrochen wird, wenn im Gegensatz zu dem G-Sender seine aktuelle Empfangsfeldstärke unter dem vorgegebenen Feldstärkenminimum liegt.

Eine vorteilhafte Ausführungsform der Erfindung ergibt sich auch aus Anspruch 8, insbesondere in Verbindung mit Anspruch 9 . Durch diese Maßnahmen wird sichergestellt, daß bei ausreichender Empfangsfeldstärke des A-Senders dieser erst dann hörbar geschaltet wird, wenn nicht nur sein aktuelles Störfreiheitsmaß größer ist als das des G-Senders, sondern er auch bereits längerfristig ein den besseren Höreindruck vermittelndes Störfreiheitsmaß besitzt. Ist hingegen sein aktueller Störfreiheitsmaß-Abtastwert kleiner als der des G-Senders, so wird seine weitere Überprüfung abgebrochen und auf den G-Sender zurückgegriffen.

Eine vorteilhafte Ausführungsform der Erfindung ergibt sich auch aus Anspruch 10. Durch diese Maßnahmen wird die Häufigkeit der erforderlichen Bestauswahl in Abhängigkeit von der Empfangsqualität des G-Senders gesteuert, um möglichst wenige Stummzeiten für die Senderüberprüfung zu benötigen. Sinkt dabei der Störfreiheitsmaß-Abtastwert des G-Senders unter eine erste Schwelle ab, was bei über dem Feldstärkeminimalwert liegendem Feldstärke-Abtastwert einer mittleren Empfangsqualität entspricht, so wird nach z.B. 30 s ein Auslösesignal zum Einleiten einer neuen Bestauswahl ausgegeben. Sinkt der Störfreiheitsmaß-Abtastwert dagegen unter eine zweite Schwelle ab, was einer schlechten Empfangsqualität entspricht, so wird bereits nach 5 s ein Auslösesignal ausgegeben. Sinkt der Störfreiheitsmaß-Abtastwert des G-Senders unter eine dritte Schwelle, was einer sehr schlechten Empfangsqualität entspricht, so erfolgt nach 0,5 s die Ausgabe des Auslösesignals. In allen Fällen wiederholt sich in diesem Zeitraster die Ausgabe weiterer Auslösesignale, wenn nicht inzwischen ein A-Sender mit besserer Empfangsqualität hörbar geschaltet wurde. Im letzten Fall der sehr schlechten Empfangsqualität ist wegen der über ein längeres Zeitintervall merkbaren Stummzeiten bei einem Schaltrhythmus von 0,5 s die Auslösesignalwiederholung auf siebenmal beschränkt. Ist danach noch kein Alternativsender mit besserer Empfangsqualität gefunden und hörbar geschaltet, wird auf einen Abprüfrhythmus von 5 s umgeschaltet.

Eine vorteilhafte Ausführungsform der Erfindung ergibt sich aus Anspruch 11. Durch diese Maßnahme wird sichergestellt, daß bei nicht ausreichender Feldstärke in jedem Fall ein Überprüfvorgang der zur Verfügung stehenden A-Sender auf bessere Empfangsqualität ausgelöst wird.

Eine vorteilhafte Weiterbildung der Erfindung ergibt sich aus Anspruch 12. Durch diese Maßnahme wird der Abprüfmodus beschleunigt, da die A-Sender entsprechend der Wahrscheinlichkeit einer besseren Empfangsqualität ausgewählt werden. Je größer die Feldstärke eines A-Senders ist, desto wahrscheinlicher ist auch, daß er eine gute Empfangsqualität besitzt.

Eine vorteilhafte Ausführungsform der Erfindung ergibt sich aus Anspruch 14. Durch diese A-Senderfortschreibung werden bei schlechter Empfangsqualität aller A-Sender automatisch solche neuen A-Sender ermittelt, die nunmehr infolge des Ortswechsels des Rundfunkgerätes empfangbar sind und möglicherweise eine bessere Empfangsqualität aufweisen. Da diese Identifizierung neuer A-Sender eine Überprüfung des gesamten Hauptspeichers und die Abstimmung möglicher A-Sender erfordert, muß der Lautsprecher für längere Zeit (Sekundenbereich) stumm geschaltet werden.

Eine vorteilhafte Ausführungsform der Erfindung ergibt sich dabei aus Anspruch 15. Durch diese Maßnahme wird eine Fortschreibung und damit eine Stummschaltung nicht unnötig, d.h. bei geringer Erfolgsaussicht, durchgeführt; denn je mehr A-Sender bereits bestimmt sind, desto unwahrscheinlicher ist es, daß es noch weitere A-Sender gibt und umgekehrt.

Eine vorteilhafte Ausführungsform der Erfindung ergibt sich auch aus Anspruch 16 . Hierdurch wird nicht nur in einfacher Weise eine Fortschreibschaltung realisiert sondern werden auch die Feldstärke und das Störfreiheitsmaß bei der Häufigkeit der Fortschreibung berücksichtigt. Sind beide sehr gut, braucht nicht fortgeschrieben zu werden. Der Runterzähler wird nicht dekrementiert. Ist die Feldstärke z.B. fortlaufend sehr klein, so findet durch laufendes Dekrementieren des Runterzählers eine Fortschreibung sehr früh statt. Da die Feldstärke an einem Standort meist für alle Sender gleich schlecht wird, ist es zweckmäßig, den Fortschreibeversuch erst dann zu starten, wenn wieder größere Feldstärke auftritt. Die Wartezeit wird dabei zeitlich begrenzt, z.B.auf 3 min, und dann auch bei sehr kleiner Feldstärke eine Fortschreibung gestartet.

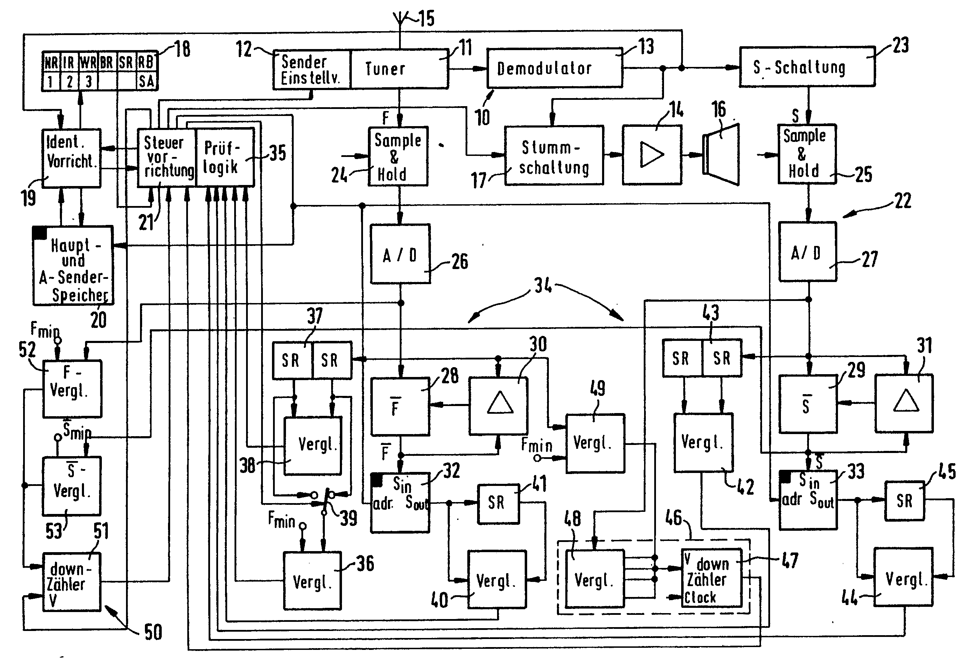

Die Erfindung ist anhand eines in der Zeichnung dargestellten Ausführungsbeispiels im folgenden näher beschrieben. Die Zeichnung zeigt dabei ein Blockschaltbild eines als Autoradio konzipierten UKW-Empfängers.

Der UKW-Empfänger weist einen Empfangsteil 10 auf, der in bekannter Weise ein UKW-Abstimmteil oder Tuner 11 mit Sendereinstellvorrichtung 12 für Sendersuchlauf oder Sendervorwahl, einen FM-Demodulator 13 und einen Niederfrequenzverstärker 14 umfaßt. Mit 15 ist die Antenne und mit 16 der Lautsprecher bezeichnet. Zwischen dem FM-Demodulator 13 und dem Niederfrequenzverstärker 14 ist hier noch eine Stummschaltung 17 eingeschaltet, mittels welcher der im Tuner 11 abgestimmte Sender hörbar oder stumm geschaltet werden kann. Mit der Sendereinstellvorrichtung 12 ist ein Bedienfeld 18 verbunden, mittels dessen das gewünschte Programm einer gewünschten Sendeanstalt vorgewählt oder durch Drücken der Taste SA für die Suchlaufautomatik ein Suchlauf der Sendereinstellvorrichtung 12 ausgelöst werden kann.

Im UKW-Empfänger ist ferner eine bekannte Senderidentifikationsvorrichtung 19 vorhanden, die einen per Suchlauf oder per Tastenanwahl eingestellten Sender nach Sendeanstalt, Programm, Sendefrequenz, Senderstandort und Senderreichweite identifiziert. Die Senderidentifikationsvorrichtung 19 greift hierzu auf einen Hauptspeicher 20 zu, in welchem alle im möglichen Aktionsradius des UKW-Empfängers empfangbaren Sender mit ihren Sendefrequenzen, Senderstandorten, abgestrahlten Programmen, ihren zugehörigen Sendeanstalten und mit ihren Senderreichweiten abgespeichert sind. Ein möglicher Aufbau der Senderidentifikationsvorrichtung 19 ist in der DE-A-2850733 beschrieben. Zusätzlich zu den dort angegebenen Funktionen ermittelt die Senderidentifikationsvorrichtung 19 zu einem empfangenen und identifizierten Sender sog. Alternativsender - im folgenden kurz A-Sender genannt -, d.h. solche empfangbaren Sender, die das gleiche Programm der gleichen Sendeanstalt abstrahlen wie der empfangene Sender. Diese A-Sender werden in einem Alternativsenderspeicher abgelegt, der mit dem Hauptspeicher 20 zusammengefaßt ist. Zweckmäßigerweise werden hierfür im Hauptspeicher nur die A-Sender kennzeichnende Marken gesetzt. Ein möglicher Ausbau der Senderidentifikationsvorrichtung 19 zur Erzielung dieser Wirkungsweise ist in der DE-A-32 14 155 beschrieben. Nach Identifizierung eines im Tuner 11 abgestimmten Senders stehen damit alle am momentanen Standort des UKW-Empfängers empfangbaren Sender mit dem gleichen Sendeprogramm wie der empfangene Sender zur Auswahl im Hauptspeicher 20 oder in dem in diesem integrierten Alternativsenderspeicher zur Verfügung. Die Senderidentifikationsvorrichtung 19 und ihr Zusammenwirken mit dem Bedienfeld 18 und der Sendereinstellvorrichtung 12 wird von einer Steuervorrichtung 21 gesteuert, die noch weitere nachfolgend beschriebene Steuerfunktionen ausführt.

Der UKW-Empfänger weist ferner eine Prüfvorrichtung 22 auf, welche die Empfangsqualität des momentan hörbaren Senders - im folgenden kurz G-Sender genannt - und die der A-Sender prüft und den Sender mit der jeweils besseren Empfangsqualität der Steuervorrichtung 21 angibt, die dann über die Sendereinstellvorrichtung 12 die Einstellung des Bestsenders bewirkt. In dieser Prüfvorrichtung 22 wird die Empfangsqualitätsprüfung nach zwei Kriterien durchgeführt: Zum einen durch Prüfen und Vergleichen der Empfangsfeldstärken und zum anderen durch Prüfen und Vergleichen eines sog. Störfreiheitsmaßes, das Störungen im Empfang berücksichtigt. Zur Bestimmung des Störfreiheitsmaßes eines Senders ist an dem Demodulator 13 eine S-Schaltung 23 angeschlossen, an deren Ausgang eine dem Störfreiheitsmaß proportionale Ausgangsspannung abnehmbar ist. Der Buchstabe S der S-Schaltung 23 steht im folgenden für Störfreiheitsmaß. Aufbau und Wirkungsweise der S-Schaltung ist in der DE-A-31 26 224 beschrieben. In der S-Schaltung 23 werden Störungen des Empfangs, wie sie z.B. durch Mehrwegeempfang oder durch den sog. Lattenzauneffekt entstehen, erfaßt. Das Störfreiheitsmaß S ist umgekehrt proportional der Häufigkeit und Größe der auftretenden Störungen.

Die Empfangsfeldstärke F und das Störfreiheitsmaß S des G-Senders werden als analoge Abtastwerte mittels einer Abtast- und Halteschaltung 24 bzw. 25 vom Tuner 11 bzw. vom Ausgang der S-Schaltung 23 abgenommen. Nach Analog/Digital-Wandlung in den A/D-Wandlern 26,27 stehen digitale F-bzw. S-Abtastwerte zur Verfügung, welche die aktuellen F- bzw. S-Werte des G-Senders bilden. Die Empfangsfeldstärke F und das Störfreiheitsmaß S der A-Sender werden in extrem kurzen Stummzeiten von 20 ms wiederum durch die Abtast- und Halteschaltungen 24,25 abgenommen. In diesen kurzen Stummzeiten wird der G-Sender durch die Stummschaltung 17 abgeschaltet und der Tuner 11 auf einen vorgegebenen A-Sender abgestimmt. Die von den Abtast- und Halteschaltungen 24,25 abgenommenen analogen F- bzw. S-Abtastwerte bilden nach Wandlung in den A/D-Wandlern 26,27 die digitalen aktuellen F- und S-Werte des A-Senders. Die Abtastfolge der Abtast- und Halteschaltungen 24,25 sowie das Aktivieren der Stummschaltung 17 wird von der Steuervorrichtung 21 gesteuert.

Für jeden einzelnen Sender, also für den G-Sender und für jeden der zur Verfügung stehenden A-Sender, werden die F-Werte einerseits und die S-Werte andererseits in einer Rechenschaltung 28 bzw. 29 einer Mittelung unterzogen. Die Rechenschaltung 28 bzw. 29 berechnet mit dem n-ten Abtastwert $A_n$ den Mittelwert $\overline{A}_n$ nach folgender Gleichung:

$$\overline{A}_n = \overline{A}_{n-1} \cdot k + (1 - k) A_n$$

A steht hierbei für den jeweiligen F- oder S-Wert. $\overline{A}_{n-1}$ ist der Mittelwert, der aus n-1 Abtastwerten gebildet worden ist. Der Verknüpfungsfaktor k wird entsprechend der Relevanz des jeweilig zu der Mittelwertbildung herangezogenen F- bzw. S-Wertszwischen den Endwerten "0" und "1" eingestellt. Bei gegenüber dem Mittelwert $\overline{A}_{n-1}$ größerem Abtastwert $A_n$ wird dabei der Faktor zu "1" und bei gegenüber dem Mittelwert $\overline{A}_{n-1}$ kleinerem Wert $A_n$ wird der Faktor zu "0" hin verschoben. Außerdem liegt der Faktor bei dem ersten bei der Mittelwertbildung zu berücksichtigenden Abtastwert $A_1$ nahe "0", da diesem ersten Abtastwert $A_1$ eine große

Relevanz zukommt. Diese Einstellung des Verknüpfungsfaktors k kann beispielsweise durch einen Differenzbildner 30 bzw. 31 erfolgen, der den momentanen Abtastwert $A_n$ und den Mittelwert $\overline{A}_{n-1}$ vergleicht und einen der Größe der Differenz entsprechenden Wert an die Rechenschaltung 28 bzw. 29 gibt. Die Mittelwerte $\overline{F}$ bzw. $\overline{S}$ werden für jeden Sender in einem $\overline{F}$-Speicher 32 und einem $\overline{S}$- Speicher 33 unter der gleichen Adresse abgelegt. Diese Adresse entspricht dabei jeweils gleich der Adresse, unter welcher der G-Sender bzw. die einzelnen A-Sender in dem Hauptspeicher 20 aufrufbar sind.

Die aktuellen F- und S-Werte und die Mittelwerte $\overline{F}$ und $\overline{S}$ des G-Senders und eines ausgewählten A-Senders werden nunmehr in einer Vergleichsschaltung 34 nach bestimmten Vergleichskriterien miteinander verglichen und der Sender mit der besten Empfangsqualität (Bestauswahl) der Steuervorrichtung 21 angegeben. Dabei wird nur die Empfangsfeldstärke F berücksichtigt, wenn der aktuelle, d.h. der gerade abgetastete und digitalisierte F-Wert des A-Senders unter einem vorgegebenen Feldstärke-Minimalwert $F_{min}$ liegt, und nur das Störfreiheitsmaß S berücksichtigt, wenn der aktuelle F-Wert des A-Senders über dem Feldstärke-Minimalwert $F_{min}$ liegt.

Die Vergleichsschaltung 34 weist eine Vielzahl von Vergleichern sowie eine Prüflogik 35 auf, die zweckmäßigerweise ein Teil der Steuervorrichtung 21 ist. Einem ersten Vergleicher 36 werden sukzessive die aktuellen F-Werte von dem G-Sender und einem zu vergleichenden A-Sender über einen von der Prüflogik 35 gesteuerten Umschalter 39 zugeführt, wozu die beiden F-Werte in einem 2 Bit-Schieberegister 37 zwischengespeichert werden. Der Vergleicher 36 vergleicht die beiden F-Werte nacheinander mit einem Feldstärke-Minimalwert $F_{min}$. In einem zweiten Vergleicher 38 werden die beiden F-Werte miteinander verglichen. In einem dritten Vergleicher 40 werden die $\overline{F}$-Werte von dem G-Sender und dem A-Sender miteinander verglichen, wozu die aus dem $\overline{F}$-Speicher 32 nacheinander ausgelesenen $\overline{F}$-Werte dem Vergleicher 40 einmal direkt ($\overline{F}$-Wert des A-Senders) und einmal über ein 1 Bit-Schieberegister 41 ($\overline{F}$-Wert des G-Senders) zugeführt werden. Die Ausgänge der drei Vergleicher 36,38 und 40 sind mit der Prüflogik 35 verbunden.

In einem vierten Vergleicher 42 werden die aktuellen S-Werte von dem G-Sender und dem A-Sender miteinander verglichen, wozu diese in einem 2 Bit-Schieberegister 43 zwischengespeichert werden. In einem fünften Vergleicher 44 werden die Mittelwerte $\overline{S}$ von A-Sender und G-Sender miteinander verglichen. Auch diese $\overline{S}$-Werte werden durch entsprechende Adressierung des $\overline{S}$-Speichers 33 sukzessive aus diesem ausgelesen, wobei der $\overline{S}$-Wert des G-Senders in einem 1 Bit-Schieberegisters 45 zwischengespeichert wird. Die Ausgänge der beiden Vergleicher 42 und 44 sind ebenfalls mit der Prüflogik 35 verbunden.

Der in den Vergleichern 36, 38, 40, 42, 44 stattfindende Vergleich zur Ermittelung des Bestsenders wird von der Prüflogik 35 in folgender Weise durchgeführt: Zunächst wird der aktuelle F-Wert des A-Senders mit dem Feldstärke-Minimalwert $F_{min}$ verglichen. Liegt dieser unter der vorgegebenen Schwelle, so wird durch Umschalten des Schalters 39 der F-Wert des G-Senders mit dem Feldstärke-Minimalwert verglichen. Ist dieser größer als die vorgegebene Schwelle, so gibt die Prüflogik 35 der Steuervorrichtung 21 den G-Sender als Bestsender an. Liegt der F-Wert des G-Senders ebenfalls unter dieser Schwelle $F_{min}$, so wird der zweite Vergleicher 38 aktiviert und die beiden F-Werte von A-Sender und von G-Sender miteinander verglichen. Ist der F-Wert des G-Senders größer als der F-Wert des A-Senders, so gibt die Prüflogik 35 der Steuervorrichtung 21 den G-Sender als Bestsender an. Ist der F-Wert des A-Senders größer als der des G-Senders, so wird der dritte Vergleicher 40 aktiviert, der die Feldstärke-Mittelwerte der beiden Sender miteinander vergleicht und den Sender mit dem größten $\overline{F}$-Wert als den Bestsender ausweist. Dieser wird von der Prüflogik 35 der Steuervorrichtung 21 mitgeteilt.

Ergibt der Vergleich im Vergleicher 36 das der F-Wert des A-Senders größer ist als der vorgegebene Feldstärke-Minimalwert, so wird der vierte Vergleicher 42 aktiviert, der die aktuellen S-Werte von G- und A- Sender miteinander vergleicht. Ist der S-Wert des A-Senders kleiner als der des G-Senders, so wird von der Prüflogik der G-Sender als Bestsender der Steuervorrichtung 21 mitgeteilt. Ist der S-Wert des A-Senders größer als der des G-Senders, so wird von der Prüflogik 35 der fünfte Vergleicher 44 aktiviert, der nunmehr die Mittelwerte $\overline{S}$ der beiden Sender miteinander vergleicht und den Sender mit dem größeren $\overline{S}$-Wert der Prüflogik 35 als Bestsender angibt, die dies wiederum an die Steuervorrichtung 21 mitteilt.

Zum Einleiten des vorstehend beschriebenen Prüfvorgangs eines Alternativsenders, der einerseits den vorstehend beschriebenen Vergleichsvorgang und andererseits die Bestimmung der zum Vergleich erforderlichen Werte umfaß, weist die Prüfvorrichtung 22 eine Abprüf-Startschaltung 46 auf, die ein zeitverzögertes Auslösesignal zum Auslesen eines A-Senders aus dem Hauptspeicher 20 und Abstimmen des ausgelesenen A-Senders im Tuner 11 ausgibt. Die Zeitverzögerung der Ausgabe des Auslösesignals ist dabei abhängig von der Größe des aktuellen S-Wertes des G-Senders einstellbar, und zwar hier in Stufen. Liegt der S-Wert unterhalb einer Oberschwelle $S_{max}$, aber in deren Nähe, so wird alle 30 s ein Auslösesignal ausgegeben. Liegt der S-Wert nahe einer unteren Schwelle $S_{min}$, so erfolgt die Ausgabe eines Auslösesignals bereits nach 5 s. Liegt der S-Wert unter der unteren Schwelle $S_{min}$, so wird ein Auslösesignal bereits nach 0,5 s an die Steuervorrichtung 21 gegeben. Eine solche Abprüf-Startschaltung 46 kann z.B. von einen voreinstellbaren Runter-Zähler (down-Zähler) 47 gebildet werden, dessen Voreinstellung von einer Vergleichsschaltung 48 vorgenommen wird, die mehrere Schwellwertstufen aufweist und mit dem jeweils aktuellen S-Wert belegt wird. Der Runter-Zähler 47 wird mit vorgegebener Clockfrequenz dekrementiert, und bei Erreichenseiner Nullstellung gibt er ein Auslösesignal an die Steuervorrichtung 21.

Mit der Abprüf-Startschaltung 46 ist noch eine Vergleichseinheit 49 verbunden, in welcher der aktuelle F-Wert des G-Senders mit dem Feldstärke-Minimalwert $F_{min}$ verglichen wird. Liegt dieser unter diesem Minimalwert $F_{min}$, so wird die Abprüf-Startschaltung 46 aktiviert, die ihrerseits ein Auslösesignal an die Steuervorrichtung 21 gibt. Dies kann wiederum dadurch bewirkt werden,daß die vergleichseinheit 49 den Runter-Zähler 47 sofort auf Null setzt.

Die Wirkungsweise des wie bisher beschriebenen Rundfunkgerätes ist nachfolgend anhand eines Beispiels zusammengestellt:
Durch Drücken der Taste SA im Bedienfeld 18 wird in der Sendereinstellvorrichtung 12 ein Sendersuchlauf bei Stummschaltung des Lautsprechers 16 durchgeführt. Der zuerst gefundene Sender wird anhand seiner Sendefrequenz in der Senderidentifikationsvorrichtung 19 identifiziert und alle A-Sender zu diesem identifizierten Sender im Hauptspeicher 20 markiert. Danach wird die Stummschaltung 17 außer Funktion gesetzt und der eingestellte Sender wird als G-Sender hörbar. Durch die Abtastund Halteschaltungen 24,25 werden bei dem G-Sender fortlaufend die Empfangsfeldstärke F und das Störfreiheitsmaß S abgetastet, digitalisiert, die Mittelwerte gebildet und die Mittelwerte unter der Adresse, unter welcher der G-Sender im Hauptspeicher 20 aufgerufen werden kann, in den Mittelwertspeichern 32 und 33 eingeschrieben. Solange der aktuelle F-Wert des G-Senders über dem Feldstärke-Minimalwert $F_{min}$ liegt (Vergleichseinheit 49) und der aktuelle S-Wert des G-Senders nicht unter die vorgegebene obere Schwelle $S_{max}$ absinkt (Vergleichsschaltung 48) wird nur diese fortlaufende Überprüfung des G-Senders durchgeführt.

Verschlechtert sich nunmehr die Empfangsqualität des G-Senders in der Weise, daß der aktuelle S-Wert geringfügig unter die obere Schwelle $S_{max}$ absinkt, so wird nach einer Zeitverzögerung von 30 s von der Abprüf-Startschaltung 46 ein Auslösesignal an die Steuervorrichtung 21 gegeben. Diese sucht in dem Hauptspeicher 20 einen Alternativsender aus, und zwar in der Reihenfolge der fallenden Empfangsfeldstärke, aktiviert die Stummschaltung 17 für 20 ms und veranlaßt die Sendereinstellvorrichtung 12 den Tuner 11 auf die neue Sendefrequenz des A-Senders abzustimmen. Von den Abtast- und Halteschaltungen 24,25 wird nunmehr die Empfangsfeldstärke F und das Störfreiheitsmaß S des engestellten A-Senders abgetastet, der Abtastwert digitalisiert und die Mittelwerte gebildet, die unter der gleichen Adresse, in welcher der A-Sender im Hauptspeicher 20 aufrufbar ist, in den beiden Mittelwertspeichern 32,33 abgelegt werden. Die Prüflogik 35 der Vergleichsschaltung 34 führt nunmehr den vorstehend beschriebenen Vergleich der F-, S-, $\overline{F}$- und $\overline{S}$-Werte des A-Senders und des G-Senders durch. Wird der G-Sender als Bestsender erkannt, so veranlaßt die Steuervorrichtung 21 die Sendereinstellvorrichtung 12 den Tuner 11 auf die Sendefrequenz des G-Senders abzustimmen. Die Aktivierung der Stummschaltung 17 wird aufgehoben. Dieser in einer Stummphase von 20 ms durchgeführte Vorgang wird von dem Hörenden nicht wahrgenommen. Nach wie vor wird er auch während dieses beschriebenen Vorgangs den G-Sender hören.

Nach weiteren 30 s - oder wenn der S-Wert des G-Senders inzwischen sich zur unteren Schwelle $S_{min}$ hin verschlechtert hat, nach bereits 5 s - gibt die Abprüf-Startschaltung 46 ein neues Auslösesignal an die Steuervorrichtung 21. Dieses aktiviert die Stummschaltung 17 und ruft aus dem Hauptspeicher 20 die Sendefrequenz eines neuen A-Senders ab und veranlaßt die Sendereinstellvorrichtung 12 den Tuner 11 auf diese Sendefrequenz abzustimmen. Wiederum werden die Empfangsfeldstärke F und das Störfreiheitsmaß S des neuen A-Senders abgetastet, die Abtastwerte digitalisiert, die Mittelwerte gebildet und die Mittelwerte unter der nächsten Adresse, unter welcher auch der neue A-Sender im Hauptspeicher 20 aufrufbar ist, in den Mittelwert-Speichern 32,33 abgelegt. Erneut wird der beschriebene Vergleichsvorgang durchgeführt. Solange der G-Sender als Bestsender ausgegeben wird, wiederholt sich der beschriebene Abprüfmodus mit jeweils einem weiteren A-Sender. Wird jedoch der überprüfte A-Sender als der Bestsender identifiziert, so hebt die Steuervorrichtung 21 lediglich die Aktivierung der Stummschaltung 17 auf und der im Tuner 11 abgestimmte A-Sender wird hörbar geschaltet. Er bildet nunmehr den neuen G-sender.

Ist die Empfangsqualität des G-Senders und aller zur Verfügung stehenden A-Sender fortlaufend schlecht, was bedeutet, daß entweder der F-Wert aller Sender unter dem Feldstärke-Minimalwert $F_{min}$ liegt oder der $\overline{S}$-Wert aller Sender fortlaufend unter einem vorgegebenen Minimalwert $\overline{S}_{min}$ des Mittelwertes des Störfreiheitsmaßes liegt oder auch beides eintritt, so erfolgt eine Fortschreibung der A-Sender, d.h. es wird versucht, an dem jetzigen neuen Empfangsort des Rundfunkgeräts empfangbare Alternativsender zu identifizieren und in die Tabelle der A-Sender einzufügen. Hierzu ist eine A-Sender-Fortschreibschaltung 50 vorgesehen, die ein eine erneute Ermittlung von A-Sendern durch die Senderidentifikationsvorrichtung 19 auslösendes Startsignal dann generiert, wenn der F-Wert und der $\overline{S}$-Wert des G-Senders fortlaufend unter dem jeweiligen Minimalwert $F_{min}$ bzw. $\overline{S}_{min}$ liegt. Die Häufigkeit der Startsignal-generierung ist dabei von der Zahl der in der Tabelle stehenden A-Sender, also von der Zahl der im Hauptspeicher 20 markierten A-Sender, umgekehrt abhängig.

Eine solche Fortschreibschaltung 50 kann durch einen voreinstellbaren Runter-Zähler (down-Zähler) 51 in Verbindung mit zwei Vergleichern 52 und 53 realisiert werden. Der F-Vergleicher 52 vergleicht dabei den aktuellen F-Wert mit dem vorgegebenen Feldstärke-Minimalwert $F_{min}$ und der $\overline{S}$-Vergleicher 53 vergleicht den Mittelwert $\overline{S}$ des G-Senders mit dem vorgegebenen Störfreiheitsmaß-Minimalwert $\overline{S}_{min}$. Die Ausgänge der beiden Vergleicher 52,53 sind mit dem Zähleingang des Runter-Zählers 51 verbunden. Über die Steuervorrichtung 21 wird der Runter-Zähler 51 auf eine Zahl voreingestellt, die umgekehrt proportional der Zahl der im Hauptspeicher 20 markierten A-Sender ist. Mit jedem Ausgangssignal der Vergleicher 52,53 wird nun der Runter-Zähler 51 dekrementiert, bis er beim Zählerstand Null ein Startsignal an die Steuervorrichtung 21 gibt. Auf dieses Startsignal hin aktiviert die Steuervorrichtung 21 die Stummschaltung 17 und die Senderidentifikationsvorrichtung 19. Letztere ermittelt eine neue Tabelle der am jetzigen Standort des Rundfunkgeräts empfangenen A-Sender oder ergänzt die bereits vorhandene A-Sender-Tabelle um neu hinzugekommene A-Sender. Die Stummschaltung wird dabei für eine längere Zeit (Sekunden) aktiviert.

Die Erfindung ist nicht auf das vorstehend beschriebene Ausführungsbeispiel beschränkt. Zweckmäßigerweise werden die Steuervorrichtung 21, die Senderidentifikationsvorrichtung 19 und die Prüfschaltung 22 mit der Vergleichsschaltung 34 und der Abprüf-Startschaltung 46 sowie die Alternativ-Fortschreibschaltung 50 von einem Mikroprozessor realisiert.

**Patentansprüche**

1. Ortsveränderliches Rundfunkgerät, wie Autoradio oder dergleichen, insbesondere UKW-Empfänger, mit einer Sendereinstellvorrichtung (12), mit einem Hauptspeicher (20), in welchem alle im möglichen Aktionsradius des Rundfunkgerätes empfangbaren Sender mit ihren Sendefrequenzen, Senderstandorten, Senderreichweiten und abgestrahlten Sendeprogrammen abgespeichert sind, mit einer Senderidentifikationsvorrichtung (19), die den momentan empfangenen Sender identifiziert und aus dem Hauptspeicher (20) am Empfangsort empfangbare, das gleiche Sendeprogramm abstrahlende Sender (Alternativ-Sender) ermittelt, mit einer Prüfvorrichtung (22), welche die Empfangsqualität des momentan hörbaren Senders (G-Sender) und die der Alternativ-Sender (A-Sender) prüft und den Sender mit der jeweils besseren Empfangsqualität angibt (Bestauswahl),
dadurch gekennzeichnet,
daß die Prüfvorrichtung (22) aufweist: eine Abtast- und Halteschaltung (24, 25), welche die Empfangsqualität des G-Senders und die Empfangsqualität der in extrem kurzen Stummzeiten kurzzeitig empfangenen A-Sender abtastet, eine Rechenschaltung (28, 29) zur Mittelung der einem Sender zugehörigen Abtastwerte, einen Speicher (32, 33) zum Abspeichern der Mittelwerte und eine Vergleichsschaltung (34), welche die Bestauswahl anhand des Vergleichs der aktuellen Abtastwerte und der Mittelwerte trifft, daß die Rechenschaltung (28, 29) zur Berechnung des n Abtastwerte eines Senders erfassenden Mittelwertes $\overline{A}_n$ den n-ten Abtastwert $A_n$ mit dem aus n-1 Abtastwerten gebildeten Mittelwert $\overline{A}_{n-1}$ gemäß

$$\overline{A}_n = \overline{A}_{n-1} \cdot k + (1 - k)\, A_n$$

verknüpft und daß der Verknüpfungsfaktor k entsprechend der dem n-ten Abtastwert zuzumessenden Relevanz einstellbar ist, wobei n eine beliebige ganze Zahl ist, und der Verknüpfungsfaktor k zwischen den Endwerten "0" und "1" auf beliebige Werte einstellbar ist, wobei der Verknüpfungsfaktor k bei gegenüber dem Mittelwert größerem aktuellen Abtastwert zu "1" und bei gegenüber dem Mittelwert kleinerem aktuellen Abtastwert zu "0" hin verschoben wird.

2. Rundfunkgerät nach Anspruch 1,
dadurch gekennzeichnet,
daß die Bestauswahl nur dann ausgelöst wird, wenn die Empfangsqualität des G-Senders einen Vorgabewert unterschreitet.

3. Rundfunkgerät nach einem der Ansprüche 1 oder 2,
dadurch gekennzeichnet,
daß die Prüfung der Empfangsqualität sowohl mit der Empfangsfeldstärke (F) als auch mit einem Störfreiheitsmaß (S) durchgeführt wird und die Bestauswahl anhand der aktuellen Abtastwerte und der getrennt berechneten Mittelwerte von Feldstärke (F) und Störfreiheitsmaß (S) erfolgt.

4. Rundfunkgerät nach Anspruch 3, **dadurch gekennzeichnet,** daß bei unter einem vorgegebenen Feldstärke-Minimalwert ($F_{min}$) liegenden aktuellen Feldstärke-Abtastwerten des A-Senders nur die Empfangsfeldstärke (F) und bei über dem Feldstärke-Minimalwert ($F_{min}$) liegenden aktuellen Feldstärke-Abtastwert des A-Senders nur das Störfreiheitsmaß (S) berücksichtigt wird.

5. Rundfunkgerät nach Anspruch 4, **dadurch gekennzeichnet,** daß die Vergleichsschaltung (34) einen mit einer minimalen Feldstärkenschwelle ($F_{min}$) belegten ersten Vergleicher (36), dem sukzessive die aktuellen Feldstärke-Abtastwerte von G-Sender und A-Sender zugeführt sind, einen Zweiten Vergleicher (38), dem die aktuellen Feldstärke- Abtastwerte von G-Sender und A-Sender zugeführt sind, einen dritten Vergleicher (40) dem die Feldstärke-Mittelwerte von G- und A-Sender Zugeführt sind, und eine Prüflogik (35) aufweist, die bei Unterschreiten der minimalen Feldstärkenschwelle ($F_{min}$) durch beide aktuelle Feldstärke-Abtastwerte den zweiten Vergleicher (38) aktiviert und bei größerem aktuellen Feldstärke-Abtastwert des A-Senders den dritten Vergleicher (40) aktiviert und den Sender mit dem größeren Feldstärke-Mittelwert als Bestsender angibt.

6. Rundfunkgerät nach Anspruch 5, **dadurch gekennzeichnet,** daß die Prüflogik (35) bei kleinerem aktuellen Feldstärke-Abtastwert des A-Senders den G-Sender als Bestsender angibt.

7. Rundfunkgerät nach Anspruch 5 oder 6, **dadurch gekennzeichnet,** daß die Prüflogik (35) bei über der minimalen Feldstärkenschwelle ($F_{min}$) liegendem aktuellen Feldstärke-Abtastwert des G-Senders und unter der minimalen Feldstärkenschwelle ($F_{min}$) liegendem aktuellen Feldstärke-Abtastwert des A-Senders den G-Sender als Bestsender abgibt.

8. Rundfunkgerät nach einem der Ansprüche 5 - 7, **dadurch gekennzeichnet,** daß die Vergleichsschaltung (34) einen vierten Vergleicher (42), dem die aktuellen Störfreiheitsmaß-Abtastwerte von G-Sender und A-Sender zugeführt sind, und einen fünften Vergleicher (44), dem die Störfreiheitsmaß-Mittelwerte von G- und A-Sender zugeführt sind, aufweist und daß die Prüflogik (35) bei über der minimalen Feldstärkenschwelle ($F_{min}$) liegendem Feldstärke-Abtastwert des A-Senders den vierten Vergleicher (42) aktiviert und bei größerem aktuellen Störfreiheitsmaß-Abtastwert des A-Senders den fünften Vergleicher (44) aktiviert und den Sender mit dem größeren Störfreiheitsmaß-Mittelwert als Bestsender angibt.

9. Rundfunkgerät nach Anspruch 8, **dadurch gekennzeichnet,** daß die Prüflogik (35) bei kleinerem aktuellen Störfreiheitsmaß-Abtastwert des A-Senders den G-Sender als Bestsender ausgibt.

10. Rundfunkgerät nach einem der Ansprüche 3 - 9, **dadurch gekennzeichnet,** daß die prüfvorrichtung (22) eine Abprüf-Startschaltung (46) aufweist, die ein zeitverzögertes Auslösesignal zum Auslösen und Abstimmen eines A-Senders ausgibt, und daß die Zeitverzögerung abhängig von der Größe des aktuellen Störfreiheitsmaß-Abtastwertes des G-Senders, vorzuweise in Stufen, einstellbar ist.

11. Rundfunkgerät nach Anspruch 10, **dadurch gekennzeichnet,** daß die Abprüf-Startschaltung (46) zusätzlich mit einer Vergleichseinheit (49) verbunden ist, die bei Unterschreiten eines vorgegebenen Feldstärke-Minimalwertes ($F_{min}$) durch den aktuellen Feldstärke-Abtastwert des G-Senders die AbprüfStartschaltung (46) aktiviert.

12. Rundfunkgerät nach Anspruch 10 oder 11, **dadurch gekennzeichnet,** daß das Auslesen der A-Sender in der Reihenfolge fallender Empfangsfeldstärke (F) der A-Sender durchgeführt wird.

13. Rundfunkgerät nach Anspruch 12, **dadurch gekennzeichnet,** daß die Feldstärke- und Störfreiheitsmaß-Mittelwerte der A-Sender unter der gleichen Adresse im Mittelwertspeicher (32,33) eingeschrieben sind, unter welcher der zugehörige A-Sender im Hauptspeicher (20) abgerufen werden kann.

14. Rundfunkgerät nach einem der Ansprüche 1 - 13 **gekennzeichnet durch** eine Alternativsender-Fortschreibschaltung (50), die ein die erneute Ermittlung von A-Sendern durch die Senderidentifikationsvorrichtung (19) auslösendes Startsignal dann generiert, wenn die Empfangsqualität des G-Senders fortlaufend unter einem Vorgabewert liegt.

15. Rundfunkgerät nach Anspruch 14, **dadurch**

**gekennzeichnet,** daß die Häufigkeit der Startsignalgenerierung von der Zahl der ermittelten A-Sender umgekehrt abhängig ist.

16. Rundfunkgerät nach Anspruch 15, **dadurch gekennzeichnet,** daß die Alternativsender-Fortschreibschaltung (50) ein den aktuellen Feldstärke-Abtastwert des G-Senders mit einem Feldstärke-Minimalwert ($F_{min}$) vergleichendes erstes Vergleichsglied (52), ein den Störfreiheitsmaß-Mittelwert des G-Senders mit einem Störfreiheitsmaß-Minimalwert ($\overline{S}_{min}$) vergleichendes zweites Vergleichsglied (53) und einen voreinstellbaren RunterZähler (51) aufweist, dessen Zähleingang mit den Ausgängen der beiden Vergleichsglieder (52,53) verbunden ist, und daß der Runter-Zähler (51) mit Ende der Alternativsender-Ermittlung auf eine von der Zahl der A-Sender umgekehrt proportionale Voreinstellziffer eingestellt ist.

**Claims**

1. Mobile radio set, such as a car radio or the like, in particular a VHF receiver, with a transmitter setting device (12), with a main memory (20), in which all the transmitters which can be received in the possible radius of action of the radio set are stored with their transmitting frequencies, transmitter locations, transmitter ranges and broadcast transmission programmes, with a transmitter identification device (19), which identifies the currently received transmitter and determines from the main memory (20) transmitters which can be received at the receiving location and are broadcasting the same transmission programme (alternative transmitters) with a testing device (22) which tests the reception quality of the transmitter which can currently be heard (H transmitter) and that of the alternative transmitters (A transmitters) and indicates the transmitter having the better reception quality in each case (best selection), characterised in that the testing device (22) has: a sample-and-hold circuit (24, 25) which samples the reception quality of the H transmitter and the reception quality of the A transmitters, received briefly during extremely short silent times, an arithmetic circuit (28, 29) for averaging the sampled values associated with a transmitter, a memory (32, 33) for storing the average values and a comparator circuit (34), which makes the best selection on the basis of the comparison of the current sampled values and average values, in that, for calculating the average value $\overline{A}_n$ covering n sampled values of a transmitter, the arithmetic circuit (28, 29) combines the nth

sampled value $A_n$ with the average value $\overline{A}_{n-1}$, formed from n-1 sampled values, as follows

$$\overline{A}_n = \overline{A}_{n-1} \cdot k + (1 - k) A_n$$

and in that the combination factor k can be set according to the relevance to be attributed to the nth sampled value, n being any whole number, and the combination factor k can be set to any values between the limit values "0" and "1", the combination factor k being shifted towards "1" in the case of a current sampled value greater than the average value and shifted towards "0" in the case of a current sampled value less than the average value.

2. Radio set according to Claim 1, characterised in that the best selection is initiated only if the reception quality of the H transmitter drops below a predetermined value.

3. Radio set according to one of Claims 1 or 2, characterised in that the testing of the reception quality is carried out both with the received field strength (F) and with a degree of freedom from interference (I) and the best selection takes place on the basis of the current sampled values and the separately calculated average values of field strength (F) and degree of freedom from interference (I).

4. Radio set according to Claim 3, characterised in that, in the case of field strength sampled values of the A transmitter lying below a predetermined field strength minimum value ($F_{min}$), only the received field strength (F) is taken into account and, in the case of the current field strength sampled values of the A transmitter lying above the field strength minimum value ($F_{min}$), only the degree of freedom from interference (I) is taken into account.

5. Radio set according to Claim 4, characterised in that the comparator circuit (34) has a first comparator (36), which is occupied by a minimum field strength threshold ($F_{min}$) and is successively fed the current field strength sampled values from H transmitter and A transmitter, a second comparator (38) which is fed the current field strength sampled values from H transmitter and A transmitter, a third comparator (40), which is fed the field strength average values from H and A transmitters, and a test logic (35), which activates the second comparator (38) if both current field strength sampled values drop below the minimum field strength threshold ($F_{min}$) and activates the third comparator (40) in the case of a relatively great current field strength sampled value of the A transmitter, and indicates the transmitter having the greater field strength average value as the best transmitter.

6. Radio set according to Claim 5, characterised in that in the case of a lower current field strength sampled value of the A transmitter, the test logic (35) indicates the H transmitter as the best transmitter.

7. Radio set according to Claim 5 or 6 characterised in that in the case of a current field strength sampled value of the H transmitter lying above the minimum field strength threshold ($F_{min}$) and a current field strength sampled value of the A transmitter lying below the minimum field strength threshold ($F_{min}$), the test logic (35) indicates the H transmitter as the best transmitter.

8. Radio set according to one of Claims 5 - 7, characterised in that the comparator circuit (34) has a fourth comparator (42) which is fed the current sampled values for the degree of freedom from interference from H transmitter and A transmitter, and a fifth comparator (44), which is fed the average values for the degree of freedom from interference from H and A transmitters, and in that, in the case of a field strength sampled value of the A transmitter lying above the minimum field strength threshold ($F_{min}$), the test logic (35) activates the fourth comparator (42) and, in the case of a greater current sampled value for the degree of freedom from interference of the A transmitter activates the fifth comparator (44), and indicates the transmitter having the greater average value for the degree of freedom from interference as the best transmitter.

9. Radio set according to Claim 8, characterised in that, in the case of a smaller current sampled value for the degree of freedom from interference of the A transmitter, the test logic (35) outputs the H transmitter as the best transmitter.

10. Radio set according to one of Claims 3 - 9, characterised in that the testing device (22) has a test-starting circuit (46), which emits a time-delayed triggering signal for initiating and tuning an A transmitter, and in that the time delay can be set, dependent on the magnitude of the current sampled value for the degree of freedom from interference of the H transmitter, preferably in stages.

11. Radio set according to Claim 10, characterised in that the test-starting circuit (46) is additionally connected to a comparator unit (49), which activates the test-starting circuit (46) if the current field strength sampled value of the H transmitter drops below a predetermined field strength minimum value ($F_{min}$).

12. Radio set according to Claim 10 or 11, characterised in that the reading-out of the A transmitters is carried out in the order of descending received field strength (F) of the A transmitters.

13. Radio set according to Claim 12, characterised in that the average values for the field strength and degree of freedom from interference of the A transmitters are written to the average-value memory (32, 33) under the same address under which the associated A transmitters can be called up in the main memory (20).

14. Radio set according to one of Claims 1 - 13, characterised by an alternative-transmitter updating circuit (50), which generates a starting signal initiating the renewed determination of A transmitters by the transmitter identification device (19) whenever the reception quality of the H transmitter persistently lies below a predetermined value.

15. Radio set according to Claim 14, characterised in that the frequency of the starting signal generation is inversely dependent on the number of determined A transmitters.

16. Radio set according to Claim 15, characterised in that the alternative-transmitter updating circuit (50) has a first comparator element (52), comparing the current field strength sampled value of the H transmitter with a field strength minimum value ($F_{min}$), a second comparator element (53), comparing the average value for the degree of freedom from interference of the H transmitter with a minimum value ($I_{min}$ for the degree of freedom from interference, and a presettable downward counter, the counting input of which is connected to the outputs of the two comparator elements (52, 53), and in that the downward counter (51) is set at the end of the alternative transmitter determination to a presetting figure inversely proportional to the number of A transmitters.

## Revendications

1. Appareil radio mobile, tel qu'auto-radio ou analogue, notamment récepteur d'ondes ultracourtes, avec un dispositif de recherche d'émetteurs (12), avec une mémoire principale (20), et dans laquelle tous les émetteurs susceptibles d'être reçus dans leur rayon d'action possible de l'appareil radio, sont mémorisés avec leurs fréquences d'émission, leurs emplacements d'émetteurs, leurs rayons d'action d'émetteurs et les programmes d'émission qu'ils diffusent, avec un dispositif d'identification d'émetteurs (19) qui identifie l'émetteur reçu à un moment donné et qui détermine à partir de la mémoire principale (20) les émetteurs (émetteurs de remplacement) susceptibles d'être reçus à l'endroit de réception et qui diffusent le même programme d'émission, avec un dispositif de contrôle (22) qui contrôle la qualité de réception de l'émetteur (émetteur G) momentanément audible, et celle des émetteurs de remplacement (émetteurs A) et qui indique l'émetteur présentant respectivement la meilleure qualité de réception (meilleur choix), appareil radio caractérisé en ce que le dispositif de contrôle (22) comporte : un circuit d'exploration et de maintien (24, 25), qui explore la qualité de réception de l'émetteur G et la qualité de réception des émetteurs A reçus pendant un bref instant dans des périodes de silence extrêmement courtes, un circuit de calcul (28, 29) pour former la moyenne des valeurs d'exploration correspondant à un émetteur, une mémoire (32, 33) pour mémoriser les valeurs moyennes et un circuit de comparaison (34), qui trouve le meilleur choix en comparant les valeurs d'exploration actuelles et les valeurs moyennes, en ce que le circuit de calcul (26, 29), permettant de calculer la valeur moyenne $\overline{A}_n$ englobant n valeurs d'exploration d'un émetteur, combine la nième valeur d'exploration $A_n$ avec la valeur moyenne $\overline{A}_{n-1}$ formée à partir de n - 1 valeur d'exploration selon l'égalité :

$$\overline{A}_n = \overline{A}_{n-1} . k + (1 - k) A_n$$

et en ce que le facteur de combinaison k est réglable de façon correspondante à l'importance devant être attribuée à la nième valeur d'exploration, n étant un nombre entier quelconque, et le facteur de combinaison k étant réglable à des valeurs quelconques entre les valeurs terminales "0" et "1", auquel cas, ce facteur de combinaison k est décalé vers "1" pour une valeur d'exploration actuelle supérieure à la valeur moyenne, et vers "0" pour une valeur d'exploration actuelle inférieure à la valeur moyenne.

2. Appareil radio selon la revendication 1, caractérisé en ce que le meilleur choix est alors déclenché lorsque la qualité de réception de l'émetteur G franchit vers le bas une valeur prédéfinie.

3. Appareil radio selon une des revendications 1 ou 2, caractérisé en ce que le contrôle de la qualité de réception s'effectue aussi bien avec l'intensité de champ de réception (F) qu'également avec une mesure d'absence de parasites (S), et le meilleur choix s'effectue à l'aide des valeurs d'exploration actuelles et des valeurs moyennes calculées séparément de l'intensité du champ (F) et de la mesure d'absence de parasites (S).

4. Appareil radio selon la revendication 3, caractérisé en ce que, dans le cas de valeurs d'exploration actuelles de l'intensité du champ de l'émetteur A, se situant au-dessous d'une valeur minimale ($F_{min}$) prédéfinie de l'intensité du champ, seule l'intensité du champ de réception (F) est prise en compte, tandis que dans le cas de valeurs d'exploration actuelles de l'intensité du champ de l'émetteur A se situant au-dessus de la valeur minimale d'intensité du champ ($F_{min}$), seule la mesure d'absence de parasites (S) est prise en compte.

5. Appareil radio selon la revendication 4, caractérisé en ce que le circuit de comparaison (34) comporte un premier comparateur (36) avec un seuil minimal d'intensité de champ ($F_{min}$), auquel sont successivement appliquées les valeurs d'exploration actuelles de l'intensité du champ de l'émetteur G et de l'émetteur A, un second comparateur (38) auquel sont appliquées les valeurs d'exploration actuelles d'intensité du champ de l'émetteur G et de l'émetteur A, un troisième comparateur (40) auquel sont appliquées les valeurs moyennes d'intensité du champ de l'émetteur G et de l'émetteur A, et une logique de contrôle (35), qui, lorsque le seuil minimal d'intensité du champ ($F_{min}$) est franchi vers le bas par deux valeurs d'exploration actuelles d'intensité du champ, active le second comparateur (38), tandis que pour une plus grande valeur d'exploration actuelle de l'intensité du champ de l'émetteur A, il active le troisième comparateur (40) et indique l'émetteur présentant la valeur moyenne d'intensité du champ la plus grande comme étant le meilleur émetteur.

6. Appareil radio selon la revendication 5, caractérisé en ce que la logique de contrôle (35), pour une valeur d'exploration actuelle d'intensité du champ plus petite de l'émetteur A, indique l'émetteur G comme étant le meilleur émetteur.

7. Appareil radio selon la revendication 5 ou la revendication 6, caractérisé en ce que la logique de contrôle (35), dans le cas d'une valeur d'exploration actuelle de l'intensité du champ de l'émetteur G se situant au-dessus du seuil minimal d'intensité du champ ($F_{min}$), et d'une valeur d'exploration actuelle d'intensité du champ de l'émetteur A se situant au-dessous du seuil minimal d'intensité du champ ($F_{min}$) indique l'émetteur G comme étant le meilleur émetteur.

8. Appareil radio selon une des revendications 5 à 7, caractérisé en ce que le circuit de comparaison (34) comporte un quatrième comparateur (42) auquel sont appliquées les valeurs d'exploration actuelles de la mesure d'absence de parasites de l'émetteur G et de l'émetteur A, et un cinquième comparateur (44) auquel sont appliquées les valeurs moyennes de la mesure de l'absence de parasites de l'émetteur G et de l'émetteur A, et en ce que la logique de contrôle (35), dans le cas où la valeur d'exploration de l'intensité du champ de l'émetteur A se situe au-dessus du seuil minimal d'intensité du champ ($F_{min}$), active le quatrième comparateur (42), et dans le cas d'une valeur d'exploration actuelle plus grande de la mesure d'absence de parasites de l'émetteur A, active le cinquième comparateur (44), et indique l'émetteur présentant la valeur moyenne de mesure de l'absence de parasites la plus grande comme étant le meilleur émetteur.

9. Appareil radio selon la revendication 8, caractérisé en ce que la logique de contrôle (35), dans le cas d'une valeur d'exploration actuelle plus petite de la mesure d'absence de parasites de l'émetteur A, indique l'émetteur G comme étant le meilleur émetteur.

10. Appareil radio selon une des revendications 3 à 9, caractérisé en ce que le dispositif de contrôle (22) comporte un circuit de démarrage du contrôle (46) qui délivre un signal de déclenchement retardé dans le temps pour le déclenchement et la syntonisation d'un émetteur A, et en ce que la temporisation est réglable en fonction de la grandeur de la valeur d'exploration actuelle de la mesure d'absence de parasites de l'émetteur G et ceci de préférence, par étages.

11. Appareil radio selon la revendication 10, caractérisé en ce que le circuit de démarrage du contrôle (46) est en outre relié à une unité de comparaison (49) qui, lors du franchissement vers le bas d'une valeur minimale prédéfinie ($F_{min}$) de l'intensité du champ par la valeur d'exploration d'intensité du champ de l'émetteur G, active le circuit de démarrage du contrôle (46).

12. Appareil radio selon la revendication 10 ou la revendication 11, caractérisé en ce que l'extraction de l'émetteur A s'effectue selon la succession des intensités de champ de réception (F) décroissante des émetteurs A.

13. Appareil radio selon la revendication 12, caractérisé en ce que les valeurs moyennes de l'intensité du champ et de la mesure d'absence de parasites des émetteurs A, sont inscrites dans la mémoire de valeurs moyennes (32, 33) sous la même adresse à laquelle l'émetteur A associé peut être appelé dans la mémoire principale (20).

14. Appareil radio selon une des revendications 1 à 13, caractérisé en ce qu'il est prévu un circuit de mise à jour (50) des émetteurs de remplacement qui engendrent alors un signal de démarrage déclenchant une nouvelle détermination d'émetteurs A par le dispositif d'identification d'émetteurs (19), lorsque la qualité de réception de l'émetteur G continue à se situer au-dessous d'une valeur prédéfinie.

15. Appareil radio selon la revendication 14, caractérisé en ce que la fréquence de la génération du signal de démarrage est inversement proportionnelle au nombre des émetteurs A déterminés.

16. Appareil radio selon la revendication 15, caractérisé en ce que le circuit de mise à jour (50) des émetteurs de remplacement, comporte un premier organe de comparaison (52) comparant la valeur d'exploration de l'intensité du champ de l'émetteur G avec une valeur minimale d'intensité du champ ($F_{min}$),un second organe de comparaison (53) comparant la valeur moyenne de la mesure d'absence de parasites de l'émetteur G avec une valeur minimale ($\overline{S}_{min}$) de la mesure d'absence de parasites, et un compteur vers le bas (51) réglable, dont l'entrée de comptage est reliée aux sorties des deux organes de comparaison (52, 53) et en ce que le compteur vers le bas (51) est réglé à la fin de la détermination des émetteurs de remplacement à un chiffre de préréglage, inversement proportionnel au nombre des émetteurs A.